(19) Europäisches Patentamt
European Patent Office
Office européen des brevets

(11) **EP 2 567 415 B1**

(12) **FASCICULE DE BREVET EUROPEEN**

(45) Date de publication et mention
de la délivrance du brevet:
**25.02.2015 Bulletin 2015/09**

(21) Numéro de dépôt: **11724264.4**

(22) Date de dépôt: **03.05.2011**

(51) Int Cl.:
***H01L 35/32*** *(2006.01)*

(86) Numéro de dépôt international:
**PCT/FR2011/000271**

(87) Numéro de publication internationale:
**WO 2011/138523 (10.11.2011 Gazette 2011/45)**

(54) **DISPOSITIF THERMOELECTRIQUE MODULABLE**

MODULIERBARE THERMOELEKTRISCHE VORRICHTUNG

MODULATABLE THERMOELECTRIC DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.05.2010 FR 1001931**

(43) Date de publication de la demande:
**13.03.2013 Bulletin 2013/11**

(73) Titulaire: **Commissariat à l'Énergie Atomique et aux Énergies Alternatives**
**75015 Paris (FR)**

(72) Inventeurs:
• **SAVELLI, Guillaume**
**F-38000 Grenoble (FR)**
• **CORONEL, Philippe**
**F-38530 Barraux (FR)**
• **PLISSONNIER, Marc**
**F-38320 Eybens (FR)**

(74) Mandataire: **Talbot, Alexandre et al**
**Cabinet Hecké**
**Europole**
**10, rue d'Arménie - BP 1537**
**38025 Grenoble Cedex 1 (FR)**

(56) Documents cités:
**DE-A1- 3 202 791     DE-A1- 3 523 773**
**FR-A1- 2 015 440**

## Description

### Domaine technique de l'invention

L'invention est relative à un dispositif thermoélectrique comprenant des plots thermoélectriques en contact avec une source chaude et une source froide. Chaque plot comprend un élément conducteur. Les éléments conducteurs, de natures thermoélectriques différentes, sont reliés entre eux pour former un thermocouple.

### État de la technique

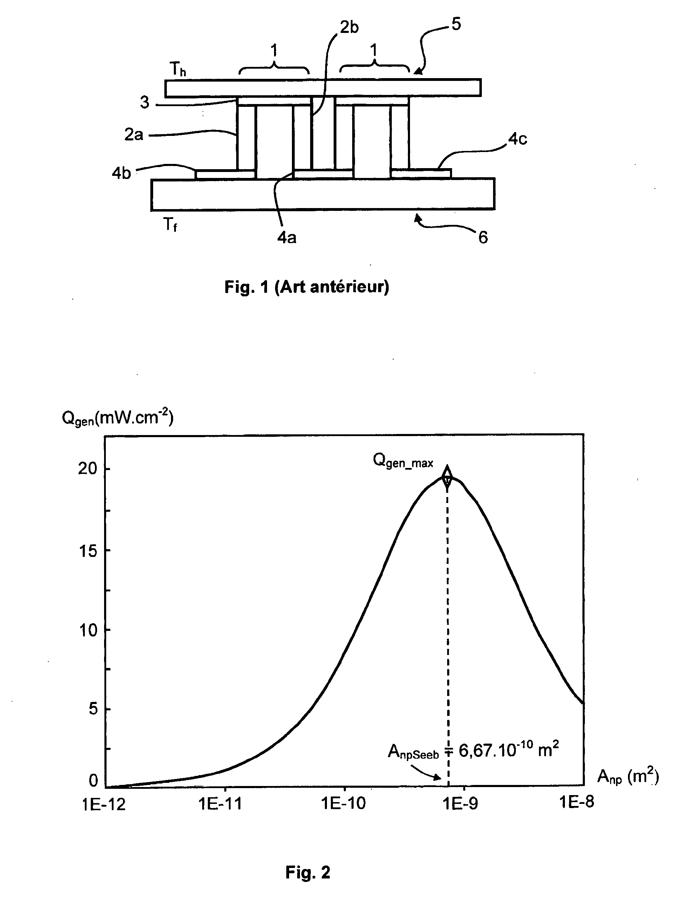

La figure 1 représente une architecture classique d'un module à thermocouples. Chaque thermocouple 1 est formé par un couple de plots 2a et 2b en matériaux conducteurs de natures différentes, reliés entre eux à l'une de leurs extrémités par un connecteur métallique 3 interne. Le plot 2a est généralement en matériau de type P et le plot 2b est généralement en matériau de type N, typiquement en silicium P et N. Un tel couple peut également être appelé « thermopaire ».

Le module comprend généralement une pluralité de thermocouples 1 reliés électriquement en série par des connecteurs métalliques 4a de liaison. Des connecteurs métalliques 4b, 4c de terminaison sont situés aux extrémités de la série de thermocouples 1 pour assurer les connexions électriques du module.

Les matériaux ou éléments conducteurs formant les plots thermoélectriques 2a et 2b sont de natures thermoélectriques différentes. Par matériaux de natures thermoélectriques différentes, on entend des matériaux de compositions chimiques différentes, aptes à former un thermocouple, ou bien un même matériau ayant des types de dopage différents.

Le module thermoélectrique peut être utilisé selon l'effet Seebeck ou selon l'effet Peltier. Il comporte un réservoir côté chaud 5 à une température $T_h$ et un réservoir côté froid 6 à une température $T_f$. Les réservoirs 5 et 6 sont disposés de part et d'autre des thermocouples 1, respectivement au niveau des connecteurs 3 et au niveau des connecteurs 4a.

En mode Seebeck, le module produit de l'énergie électrique à partir d'un gradient de température entre le côté chaud 5 et le côté froid 6. Ce mode est aussi appelé mode générateur de puissance.

En mode Peltier, l'application d'un courant aux bornes du module permet de générer un gradient de température entre le côté chaud 5 et le côté froid 6. Ce mode est aussi appelé mode refroidisseur.

Le rendement du module thermoélectrique dépend des matériaux utilisés, de sa géométrie et de l'environnement d'utilisation. Un module classique est donc soit optimisé pour le mode refroidisseur, soit pour le mode générateur de puissance, mais jamais pour les deux à la fois.

DE 3202791 A1 divulgue un dispositif thermoélectrique dont l'opération du thermocouple est modifié par l'insertion d'une languette.

### Résumé de l'invention

L'invention vise un dispositif thermoélectrique unique et compact, pouvant fonctionner, au choix, soit en mode Seebeck, soit en mode Peltier de façon optimale.

On tend vers ces objectifs par le fait que le dispositif thermoélectrique comprend des premier et second plots ayant des premières extrémités en contact avec une première face et des secondes extrémités en contact avec une seconde face. Les premier et second plots comprennent respectivement des premier et deuxième éléments conducteurs s'étendant continûment entre les première et seconde faces. Les premier et second plots comprennent respectivement des troisième et quatrième éléments conducteurs s'étendant continûment entre les première et seconde faces. Le troisième élément conducteur est adjacent au premier élément conducteur et séparé du premier élément conducteur par un isolant. Le quatrième élément conducteur est adjacent au deuxième élément conducteur et séparé du deuxième élément conducteur par un isolant. Le dispositif comprend également des moyens de sélection permettant la formation d'un premier thermocouple à partir des premier et deuxième éléments conducteurs et la formation d'un second thermocouple à partir des troisième et quatrième éléments conducteurs.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1 représente un module thermoélectrique selon l'art antérieur,

- la figure 2 représente un graphe de la puissance électrique générée par un dispositif thermoélectrique en mode Seebeck en fonction de la section des plots,

- la figure 3 représente un graphe de la puissance calorifique générée par un dispositif thermoélectrique en mode Peltier en fonction de la section des plots,

- la figure 4 représente, de manière schématique, un dispositif thermoélectrique générique selon l'invention,

- les figures 5 et 6 représentent un plot d'un premier mode de réalisation de dispositif selon l'invention,

- la figure 7 représente un dispositif thermoélectrique comprenant deux plots de la figure 6 reliés par un élément de connexion électrique,

- les figures 8 et 9 représentent une variante de réalisation de l'élément de connexion électrique du dispositif de la figure 7,

- la figure 10 représente un second mode de réalisation d'un dispositif selon l'invention,

- les figures 11 et 12 représentent, en vues de coupe, des éléments de connexion électrique du dispositif de la figure 10,

- les figures 13 à 21 représentent des étapes d'un procédé de réalisation du dispositif de la figure 10,

- la figure 22 représente, en coupe, une étape de réalisation de l'élément de connexion de la figure 11,

- la figure 23 représente, en coupe, une variante de réalisation de l'étape de la figure 22, et

- les figures 24 et 25 représentent, en coupe, des étapes de réalisation de l'élément de connexion de la figure 12.

## Description d'un mode de réalisation préféré de l'invention

Un dispositif thermoélectrique peut être optimisé en adaptant sa géométrie aux conditions d'utilisation et au mode de fonctionnement désiré. Une modélisation, obtenue à l'aide des équations générales de la thermoélectricité et de la thermique, peut être utilisée pour déterminer cette géométrie optimale.

Un cas d'étude, basé sur le module de la figure 1, est décrit ci-dessous. Il permet de mettre en évidence que l'optimisation du dispositif en mode Seebeck diffère de celle du mode Peltier.

Le tableau 1 regroupe les paramètres électriques, thermiques et géométriques du dispositif thermoélectrique utilisés dans cette modélisation. Pour définir l'environnement du dispositif, un échangeur thermique est disposé entre le dispositif et le réservoir froid 6. Ses caractéristiques sont également indiquées dans le tableau 1.

Les paramètres de la première catégorie (température) sont la température $T_h$ du côté chaud 5 et la température $T_f$ du côté froid 6, en Kelvin.

La deuxième catégorie de paramètres définit les caractéristiques intrinsèques des matériaux comme le coefficient Seebeck S, la conductivité thermique $\lambda$ et la résistivité électrique $\rho$ des matériaux électriquement conducteurs formant les plots, ainsi que la conductivité thermique $\lambda_{MAT}$ de la matrice, c'est-à-dire du matériau électriquement isolant entre les plots.

La troisième catégorie caractérise la géométrie du dispositif, c'est-à-dire le nombre de plots n (avec N=n/2 étant égal au nombre de thermocouples), la hauteur L des plots, la section $A_{np}$ des plots définie dans le cas présent par un carré de côté b ($A_{np}=b^2$), la distance d entre deux plots consécutifs et la surface disponible $A_{te}$ sur laquelle sont répartis les plots.

**Tableau 1**

| Catégories | Paramètres | Variables | Valeurs |
|---|---|---|---|
| **Température** | Température réservoir chaud | $T_h$ | 350 K |
| | Température réservoir froid | $T_f$ | 300 K |
| **Matériaux** | Coefficient Seebeck | S | 4.00E-04 V/K |
| | Conductivité thermique | $\lambda$ | 1,5 W/m/K |
| | Résistivité électrique | $\rho$ | 1.60E-05 $\Omega$.m |
| | Conductivité thermique matrice | $\lambda_{MAT}$ | 0,026 W/m/K |

(suite)

| Catégories | Paramètres | Variables | Valeurs |
|---|---|---|---|
| Géométrie | Nombre de plots | n | 1.00E+04 |
| | Hauteur des plots | L | 4.00E-05 m |
| | Côté des plots | b | **VAR** en m |
| | Section des plots | $A_{np}$ | **VAR** en m$^2$ |
| | Distance entre deux plots | d | **VAR** en m |
| | Surface disponible | $A_{te}$ | 1,00E-04 m$^2$ |
| Échange | Surface de diffusion thermique | $A_{hs}$ | 2.00E-04 m$^2$ |
| | Coefficient de transfert de chaleur | h | 1.00E+03 W/m$^2$/K |
| Résistivité | Résistance de contact | $R_C$ | 1,00E-11 $\Omega$.m$^2$ |
| | Résistance interne du dispositif | $R_{int}$ | **VAR** en $\Omega$ |

Les paramètres de la catégorie « échange » caractérisent l'environnement du dispositif du côté froid : la surface de diffusion thermique $A_{hs}$ de l'échangeur et le coefficient de transfert de chaleur h de l'échangeur entre le dispositif et le réservoir côté froid ou source froide. Cette source froide est, par exemple, l'air à température ambiante ($T_f$ = 300K) et l'échangeur thermique avec cet air peut être une plaque métallique ou un substrat sur lequel sont formés les plots.

Les paramètres de la catégorie « résistivité » sont la résistance de contact $R_C$, représentant la qualité du contact entre chaque plot 2a, 2b et les connecteurs 3, 4a, 4b et 4c, et la résistance interne $R_{int}$, correspondant à la résistance totale du dispositif mesurée aux bornes de la série de thermocouples.

Dans cet exemple de modélisation, les côtés chaud et froid sont respectivement à des températures $T_h$ égale à 350 Kelvin et $T_f$ égale à 300 Kelvin. La surface du module $A_{te}$ est fixée à 1 cm$^2$ sur laquelle sont répartis 10000 plots soit 5000 thermocouples. Les plots ont une longueur de 40 $\mu$m et sont séparés par de l'air. Enfin les paramètres liés à l'échangeur thermique sont une surface $A_{hs}$ de 2 cm$^2$ et un coefficient de transfert de chaleur h de 1000 W.m$^{-2}$.K$^{-1}$.

La température ($T_f$) du côté froid 6 ne correspond pas réellement à la température froide du thermocouple, au niveau du connecteur 4a, à cause notamment de la diffusion de chaleur du côté chaud 5. Ainsi, le côté froid du thermocouple est à une température $T_c$ supérieure à la température $T_f$. C'est donc la différence de température du dispositif $T_h$-$T_c$ qui est prise en compte dans les équations et non la différence de température de l'environnement $T_h$-$T_f$.

Il est proposé d'étudier l'influence de la section des plots $A_{np}$ sur les performances d'un dispositif thermoélectrique fonctionnant selon l'effet Seebeck, puis selon l'effet Peltier. Les paramètres b et $A_{np}$ correspondant respectivement au côté et à la section des plots sont donc variables.

La puissance électrique générée $Q_{gen}$ en mode Seebeck peut être exprimée à l'aide des paramètres du tableau 1 par la relation :

$$Q_{gen} = \frac{N^2 \times S^2 \times \left(T_h - T_c(A_{np})\right)^2}{4R_{int}^2(A_{np}) \times A_{hs}} \qquad (1)$$

La relation (1) fait intervenir les paramètres $T_c$ et $R_{int}$, tous deux inconnus et dépendant de la section des plots $A_{np}$.

La résistance interne $R_{int}$ s'écrit :

$$R_{int}(A_{np}) = 2N \times \left(\frac{\rho \times L}{A_{np}} + \frac{2R_C}{A_{np}}\right) \qquad (2)$$

Pour connaître l'expression de $T_c$, il faut écrire l'équation présentant le bilan des puissances au niveau de l'échangeur thermique :

$$P_{Seeb} + P_{cond} + P_j = P_{hs} \qquad (3)$$

où $P_{Seeb}$ représente la puissance thermoélectrique générée à l'interface avec l'échangeur (à la température $T_c$), $P_{cond}$ représente la puissance transférée par conduction, $P_j$ la puissance générée par effet Joule et $P_{hs}$ la puissance évacuée par convection (naturelle ou forcée) au niveau de l'échangeur. Ces quatre termes font intervenir $T_c$. En remplaçant chacun des termes par son expression, l'équation (3) devient :

$$N \times S \times T_c \times I + \left( \frac{2N \times \lambda \times \Delta T \times A_{np}}{L} + \frac{\lambda_{air} \times \Delta T \times A_{air}}{L} \right) + \frac{1}{2} R_{int} \times I^2 = \left( T_c - T_f \right) h A_{hs} \qquad (4)$$

où $\Delta T$ représente la différence de température $T_h$-$T_c$, $\lambda_{air}$ la conductivité thermique de l'air séparant les plots, I le courant généré par la série de thermocouples et $A_{air}$ la surface d'échange avec l'air, côté dispositif ($A_{air}= A_{te}$-2N.Anp).

Ainsi, l'expression de $T_c$ en fonction du paramètre $A_{np}$ peut être obtenue à partir de la relation (4).

En remplaçant la résistance interne $R_{int}$ et la température $T_c$ dans la relation (1) par leurs expressions respectives (2) et (4), la puissance électrique générée $Q_{gen}$ peut être exprimée uniquement en fonction de la section des plots $A_{np}$.

La figure 2 représente l'évolution de $Q_{gen}$ en fonction de la section des plots $A_{np}$. On peut remarquer que le maximum de puissance $Q_{gen\_max}$ est obtenu pour une section $A_{npSeeb}$ = 6,67. $10^{-10}$ $m^2$, correspondant à un carré de côté b=26 $\mu$m.

Cette valeur $A_{npSeeb}$ peut aussi être obtenue analytiquement en résolvant l'équation :

$$\left( \frac{\partial Q_{gen}}{\partial A_{np}} \right)_{A_{np} = A_{npSeeb}} = 0 = \left( \frac{\partial \left( \frac{N^2 \times S^2 \times \left( T_h - T_c(A_{np}) \right)^2}{4 \times (R_{int}(A_{np}))^2 \times A_{hs}} \right)}{\partial A_{np}} \right)_{A_{np} = A_{npSeeb}} \qquad (5)$$

De manière analogue, la modélisation peut être effectuée pour un dispositif fonctionnant selon l'effet Peltier. Un courant d'entrée I de 10 mA est appliqué au dispositif thermoélectrique. En prenant en compte la puissance générée par effet Peltier, les pertes par effet Joule et par conduction thermique, la puissance en froid d'un dispositif thermoélectrique en mode Peltier peut s'écrire sous la forme :

$$Q_{froid} = N \times S \times I \times T_c - \frac{1}{2} R_{int}(A_{np}) \times I^2 - K(A_{np}) \times (T_h - T_c) \qquad (6)$$

Cette équation (6) fait intervenir la variable $A_{np}$ représentative de la section des plots, I le courant traversant la série de thermocouples et $K(A_{np})$ la conductance thermique totale. Cette dernière peut s'écrire:

$$K(A_{np}) = \frac{2N \times \lambda \times A_{np}}{L} + \frac{\lambda_{air} \times (A_{te} - 2N \times A_{np})}{L} \qquad (7)$$

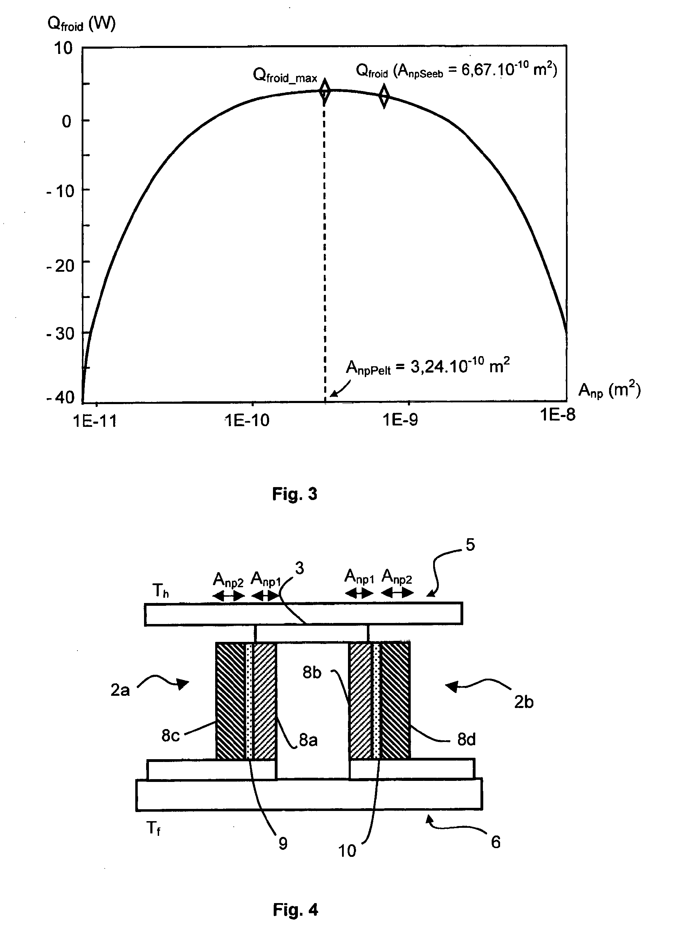

La figure 3 représente l'évolution de $Q_{froid}$ en fonction de la section des plots $A_{np}$, obtenue à partir des expressions (2), (6), (7) et des valeurs des paramètres du tableau 1. Dans le cas présent, ces paramètres sont différents du mode Seebeck. Ainsi, un courant d'entrée égal à 10 mA traverse la série de thermocouples.

Dans ces conditions, si la section du plot était égale à celle déterminée précédemment pour le mode Seebeck, une puissance $Q_{froid}$ de 3,2 W serait obtenue. La lecture de la courbe de la figure 3 montre que cette valeur de 3,2 W n'est pas optimale. En effet, une puissance maximale $Q_{froid\_max}$ de 3,94 W peut être obtenue pour une section $A_{npPelt}$ = 3,24.$10^{-10}$ $m^2$, soit un carré de côté b de 18 $\mu$m environ.

Cette section des plots optimisée pour le mode Peltier est donc inférieure à celle utilisée pour optimiser un même dispositif thermoélectrique pour le mode Seebeck.

Cet exemple de modélisation montre que la section de plot optimale varie en fonction du mode de fonctionnement. Contrairement aux modules classiques optimisés pour l'un seulement des effets Peltier et Seebeck, le dispositif décrit ci-dessous présente une architecture permettant de moduler la section des plots pour obtenir dans un même module, un rendement maximum dans chacun des deux modes de fonctionnement.

La figure 4 représente, de manière schématique, un mode de réalisation générique de dispositif thermoélectrique à plots de section variable. Le dispositif comprend deux plots thermoélectriques 2a et 2b connectés thermiquement en parallèle entre deux sources de chaleur et électriquement en série pour former au moins un thermocouple.

Chaque plot a une première extrémité en contact avec une source de chaleur 5 et une seconde extrémité en contact avec une source de chaleur 6. La source 5 constitue, par exemple, la face chaude du dispositif thermoélectrique tandis que la source 6 constitue la face froide. L'expression « source de chaleur » désignera par la suite soit un réservoir froid ou chaud participant au gradient de température du dispositif en mode Seebeck, soit l'environnement qui est refroidi en mode Peltier.

Le dispositif utilise des plots dont chacun est constitué de plusieurs éléments conducteurs, agencés, de préférence, parallèlement les uns aux autres et séparés par une couche en matériau électriquement isolant. Ainsi, par « plot thermoélectrique » on entend ici une pièce en plusieurs éléments conducteurs solidaires, chaque élément s'étendant sur toute la hauteur du plot entre les sources de chaleur 5 et 6.

Cette architecture de plot permet la formation de deux thermocouples ayant des sections différentes en connectant électriquement différents éléments conducteurs. On sélectionne ensuite l'un ou l'autre des deux thermocouples selon le mode de fonctionnement désiré.

Chacun des plots 2a et 2b comporte ainsi un premier élément électriquement conducteur, respectivement 8a et 8b. Les éléments 8a et 8b s'étendent continûment de la source chaude 5 à la source froide 6. De préférence, l'élément conducteur 8a du plot 2a et l'élément conducteur 8b du plot 2b sont de mêmes dimensions et ont une même section, notée $A_{np1}$ sur la figure 4.

Chacun des plots 2a, 2b du dispositif thermoélectrique comprend, de plus, un deuxième élément électriquement conducteur. Ainsi, le plot 2a comporte un élément conducteur 8c adjacent à l'élément 8a et séparé de l'élément 8a par un isolant électrique 9. De même, le plot 2b comprend un élément conducteur 8d adjacent à l'élément 8b et séparé de l'élément 8b par un isolant électrique 10. Les éléments conducteurs 8c et 8d sont, de préférence de mêmes dimensions. Leur section est notée $A_{np2}$.

Les matériaux formant les éléments conducteurs peuvent être choisis parmi des semi-conducteurs, par exemple le silicium et le germanium, ou des semi-métaux, notamment l'antimoine ou le bismuth. Les isolants 9 et 10 sont des matériaux, de préférence identiques, choisis parmi les résines, les nitrures, les oxydes et l'air par exemple.

Dans les modes de réalisation suivants, un premier thermocouple est formé à partir des éléments conducteurs 8a et 8b tandis qu'un second thermocouple est formé à partir des éléments 8c et 8d. Les matériaux formant les éléments 8a et 8b sont donc de natures thermoélectriques différentes, par exemple des alliages silicium-germanium dopés n et p. Les matériaux formant les éléments 8c et 8d sont également de natures thermoélectriques différentes. De plus, les matériaux constituant les éléments 8a et 8c peuvent être identiques ou non, de même que ceux des éléments 8b et 8d.

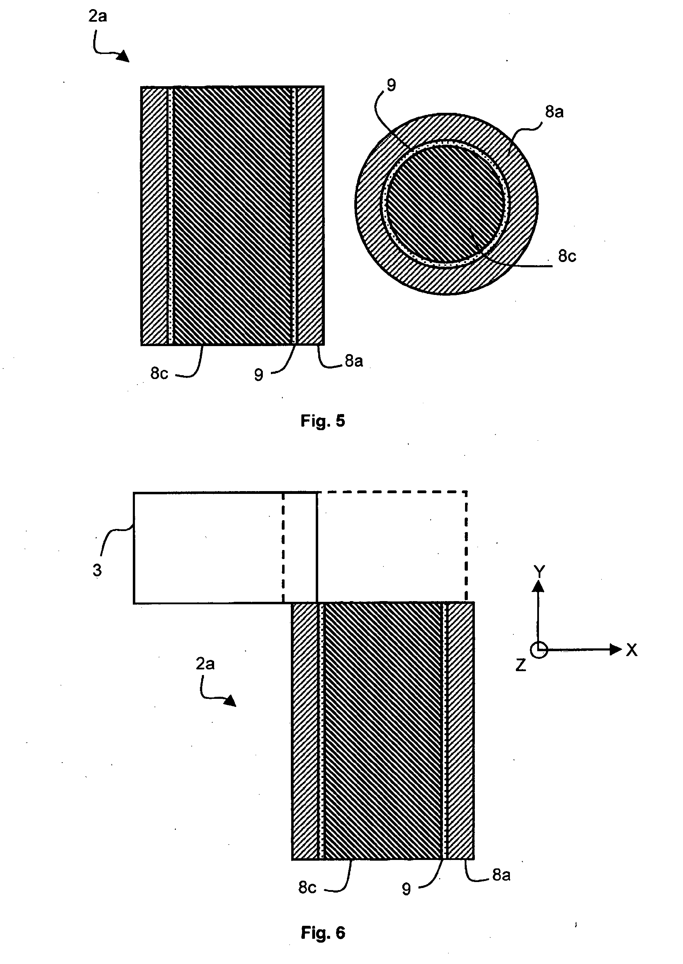

Les figures 5 à 7 représentent plusieurs détails d'un premier mode de réalisation d'un dispositif à plot de section modulable.

La figure 5 représente, en vue de face (à gauche) et en vue de dessus (à droite), un plot thermoélectrique 2a du dispositif de la figure 4. Dans ce mode de réalisation, le coeur du plot 2a est constitué par l'élément conducteur 8c sous la forme d'un cylindre. Ce dernier a une surface cylindrique recouverte par le matériau électriquement isolant 9. Une couronne est formée autour du matériau 9 et de l'élément cylindrique 8c par l'élément 8a, lui aussi cylindrique. Ainsi, les éléments 8a et 8c du plot 2a sont des cylindriques concentriques, séparés par le matériau isolant 9. Le deuxième plot est de configuration similaire.

La figure 6 représente un mode de connexion électrique associé à cette configuration de plot. Les cylindres de chaque plot sont debout sur un substrat (non représenté). Le substrat se situe, par exemple, dans un plan parallèle au plan (xz). Les cylindres formant chaque plot possèdent donc un axe commun dirigé selon y.

Un élément de connexion électrique 3 est mobile sur une face externe du plot 2a, qui expose les éléments 8a et 8c. Dans le cas de la figure 6, la face externe du plot, en contact avec le connecteur électrique 3, correspond à la face supérieure des éléments 8a et 8c. Le connecteur se déplace, par exemple, selon la direction x.

Dans une première position représentée en trait plein sur la figure 6, le connecteur 3 prend contact avec la couronne du plot uniquement, c'est-à-dire avec l'élément 8a. Dans une seconde position représentée en pointillés, le connecteur 3 est en contact avec l'élément 8a et l'élément 8c. Il relie donc électriquement les deux éléments cylindriques.

De façon analogue, le connecteur 3 se déplace sur une face externe du plot 2b qui expose les éléments 8b et 8d.

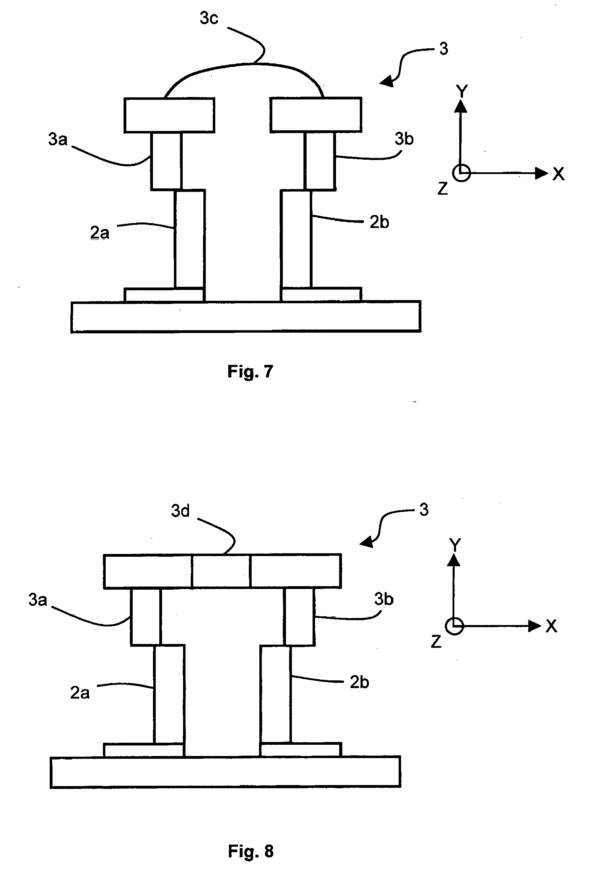

La figure 7 illustre en vue d'ensemble le dispositif thermoélectrique selon ce premier mode de réalisation. Les plots 2a et 2b, du typé représenté à la figure 5, sont associés à un connecteur 3 mobile, comme celui décrit en relation avec la figure 6.

Lorsque le connecteur 3 est en contact sur la couronne extérieure des plots 2a et 2b, comme schématisé sur les figures 6 et 7, une connexion électrique entre les éléments 8a et 8b est réalisée formant ainsi le premier thermocouple. La section des matériaux conducteurs participant à ce thermocouple vaut alors $A_{np1}$. Lorsque le connecteur 3 recouvre au moins en partie les éléments 8a, 8b, 8c et 8d (en pointillés sur la figure 6), une connexion électrique entre tous les éléments est effectuée. Alors, un second thermocouple ayant une section égale à la somme de $A_{np1}$ et $A_{np2}$ est obtenu.

Le premier thermocouple est, par exemple, optimisé pour un fonctionnement selon l'effet Peltier. Dans ce cas, la section $A_{np1}$ des éléments 8a et 8b est choisie de manière à obtenir un maximum de puissance en froid. Le second thermocouple formé par les deux paires d'éléments conducteurs est, par exemple, utilisé pour un fonctionnement en mode Seebeck. La section correspondante, égale à la somme des sections des éléments 8a et 8c, est choisie pour optimiser la génération de courant.

Le connecteur 3 comporte, dans le mode de réalisation de la figure 7, une première partie 3a en contact avec le plot 2a et une seconde partie 3b en contact avec le plot 2b. Les parties 3a et 3b sont reliées électriquement, par exemple, par un fil électrique 3c. Les parties 3a et 3b sont mobiles l'une par rapport à l'autre. Ainsi, chaque partie peut être déplacée indépendamment par le biais d'un actionneur électromécanique par exemple.

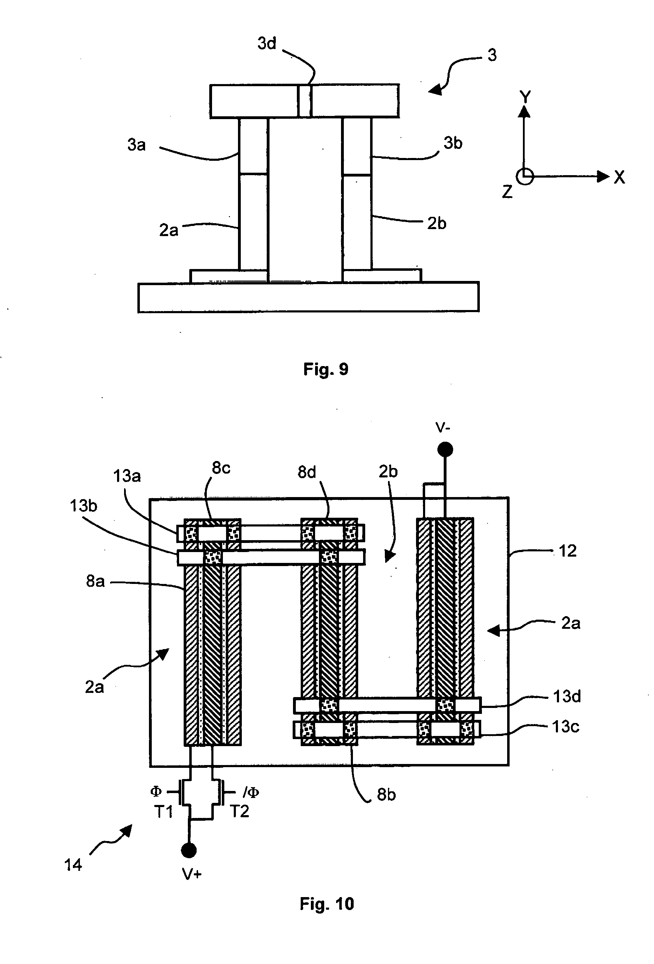

Les figures 8 et 9 illustrent une variante de réalisation du connecteur 3. Celui-ci peut être formé d'une seule pièce comprenant une partie centrale 3d en matériau déformable et électriquement conducteur. Ainsi, les parties 3a et 3b du connecteur 3, en contact respectivement avec les plots 2a et 2b, peuvent être déplacées simultanément dans des sens opposés en comprimant ou dilatant le matériau déformable 3d.

La position des parties 3a et 3b de la figure 8 peut correspondre à une position de repos, en absence d'effort sur la partie déformable 3d. En comprimant la partie déformable 3d (figure 9), la partie 3a est déplacée selon la direction x et la partie 3b est déplacée selon la direction -x pour réaliser le second thermocouple. Inversement, la position de repos peut correspondre à la figure 9. Alors, les parties 3a et 3b peuvent être mises en contact avec la couronne extérieure de chaque plot uniquement en dilatant le matériau 3d. Le matériau déformable est, par exemple, un matériau à changement de forme.

Les plots cylindriques 2a et 2b peuvent être constitués par des nanofils en matériaux semi-conducteurs. Dans une première étape, on effectue une croissance de nanofils dans un premier matériau, par exemple du silicium, sur un substrat. Les nanofils sont ensuite oxydés en surface pour former la couche en matériau isolant entre les deux éléments conducteurs, par exemple un oxyde de silicium $SiO_2$. Enfin, lors d'une dernière étape, on réalise une nouvelle croissance d'un second matériau (silicium par exemple) qui recouvre le matériau isolant.

Les figures 10 à 12 représentent un deuxième mode de réalisation d'un dispositif thermoélectrique à plot de section modulable.

La figure 10 illustre un dispositif dans lequel trois plots thermoélectriques 2a, 2b et 2a sont allongés côte à côte sur un substrat 12. Par opposition à l'architecture verticale représentée sur les figures 1, 4 à 9, cette configuration s'appuie sur une réalisation plane, par exemple par dépôt puis structuration de couches.

Le dispositif comprend une première connexion électrique 13a entre les éléments 8a et 8b pour former le premier thermocouple et une seconde connexion électrique 13b entre les éléments 8c et 8d pour former le second thermocouple. La section $A_{np1}$ des éléments 8a et 8b est différente de la section $A_{np2}$ des éléments 8c et 8d. Ainsi, les premier et second thermocouples ont des sections de tailles différentes. L'une d'elles est, de préférence, optimisée pour un fonctionnement en mode Seebeck tandis que l'autre est optimisée pour un fonctionnement en mode Peltier.

La première connexion électrique 13a peut être réalisée par une couche métallique 13a reliant les éléments 8a et 8b, de préférence, à une extrémité des plots 2a et 2b. Une couche métallique 13b, disposée de préférence à proximité et en parallèle de la couche 13a, relie les éléments 8c et 8d.

Chacun des thermocouples est, de préférence, relié en série avec d'autres thermocouples de même nature, formés par les couples de plots 2a, 2b successifs. Ainsi, l'élément extérieur 8b du plot 2b est relié électriquement à l'élément extérieur du plot 2a suivant, à droite sur la figure 10, par une couche métallique 13c. De même, le coeur 8d du plot 2b est relié électriquement au coeur du plot 2a du thermocouple suivant par une couche métallique 13d.

Les couches métalliques 13c et 13d sont, de préférence, formées de la même manière que les couches 13a et 13b à l'extrémité opposée des plots. Ainsi, deux chemins électriques indépendants sont créés à partir des éléments conducteurs.

Les deux séries de thermocouples sont reliées à un circuit électrique externe (non représenté) par un dispositif de commutation 14. Le dispositif 14 connecte l'un ou l'autre des deux chemins électriques à des bornes d'entrée-sortie V+ et V-. Ces bornes d'entrée-sortie V+ et V- sont des bornes d'alimentation du dispositif lorsque celui-ci fonctionne en mode Peltier. A l'inverse, en mode Seebeck, les bornes d'entrée-sortie V+ et V- sont des bornes d'alimentation du circuit externe.

Dans un exemple de réalisation représenté sur la figure 10, le dispositif 14 comprend deux interrupteurs T1 et T2, par exemple de type transistor MOS. Chaque interrupteur est disposé dans un chemin électrique entre l'une des bornes d'entrée-sortie V+, V- et la série de thermocouples associée.

Les interrupteurs T1 et T2 sont commandés par des signaux en opposition de phase Φ et /Φ. De cette manière, une seule série de thermocouples est connectée au circuit externe (une alimentation ou une charge) à chaque instant. A titre d'exemple, le transistor T1 est rendu passant par un signal Φ pour un fonctionnement selon l'un des deux effets Peltier et Seebeck en utilisant la série des premiers thermocouples. Le transistor T2 est rendu passant par un signal /Φ en opposition de phase pour un fonctionnement selon l'autre effet avec la série des seconds thermocouples.

Dans ce mode de réalisation, l'élément 8a est en deux parties disposées de chaque côté de l'élément 8c de façon symétrique. De même, l'élément 8d est disposé de part et d'autre de l'élément 8b, également de façon symétrique. Cependant, le dispositif n'est pas limité à cette configuration symétrique. En particulier, les éléments 8a et 8c peuvent être côte à côte comme cela est représenté sur la figure 4.

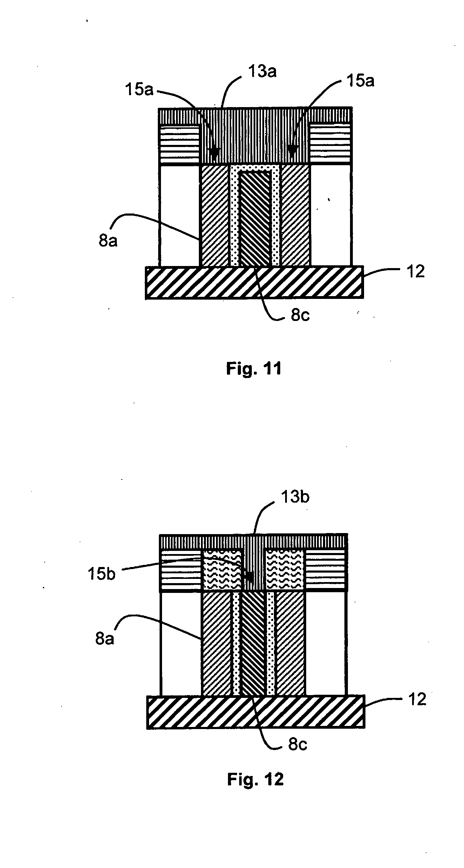

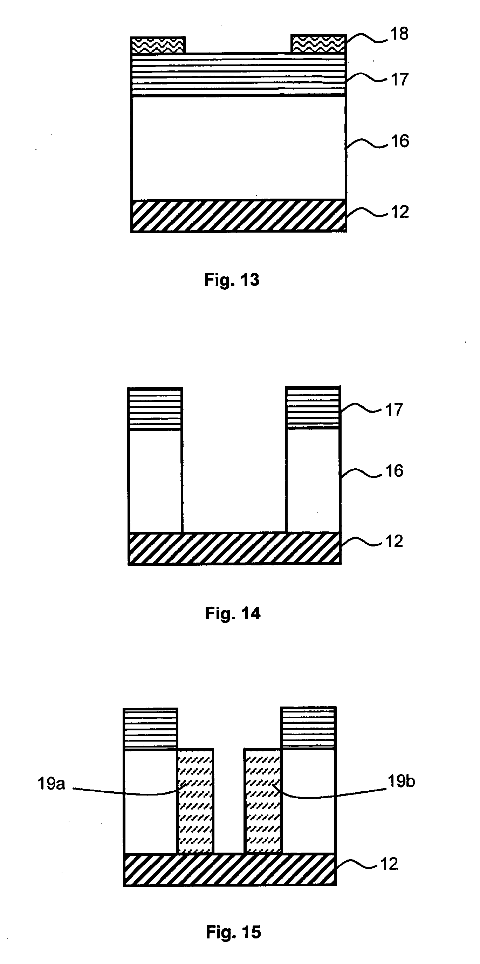

Les figures 11 et 12 représentent des vues en coupe du dispositif de la figure 10 au niveau des connexions électriques réalisées respectivement par la couche 13a sur l'élément conducteur 8a et par la couche 13b sur l'élément conducteur 8c. Les éléments 8a et 8c en matériaux conducteurs sont entourés de matériaux isolants électriquement. Une partie supérieure des matériaux isolants est enlevée pour permettre soit l'accès à l'élément 8a dans les zones 15a (Fig.12), soit l'accès à l'élément 8c dans la zone 15b (Fig.13).

Les figures 13 à 21 représentent une première série d'étapes d'un procédé de réalisation d'un plot thermoélectrique selon la figure 10.

A la figure 13, des couches 16 et 17 en matériau électriquement isolant sont déposées sur le substrat 12. Un masque de gravure 18 est ensuite réalisé sur la couche 17. Le masque 18 comprend, de préférence, une résine structurée par photolithographie. L'ouverture définie par le masque a des dimensions correspondant à celle d'un plot thermoélectrique.

A la figure 14, les couches diélectriques 16 et 17 sont ensuite gravées, de manière anisotrope, à travers le masque 18. Le masque 18 est ensuite retiré sélectivement par rapport aux couches 16 et 17, par exemple par une gravure plasma de type $O_2$.

La figure 15 représente la réalisation d'espaceurs 19a et 19b sur le substrat 12 dans la zone précédemment gravée. Les espaceurs sont, de préférence, formés par le dépôt conforme d'une couche en matériau sacrificiel et une gravure anisotrope du matériau sacrificiel. Le matériau sacrificiel est, par exemple, le dioxyde de silicium ou le nitrure de silicium.

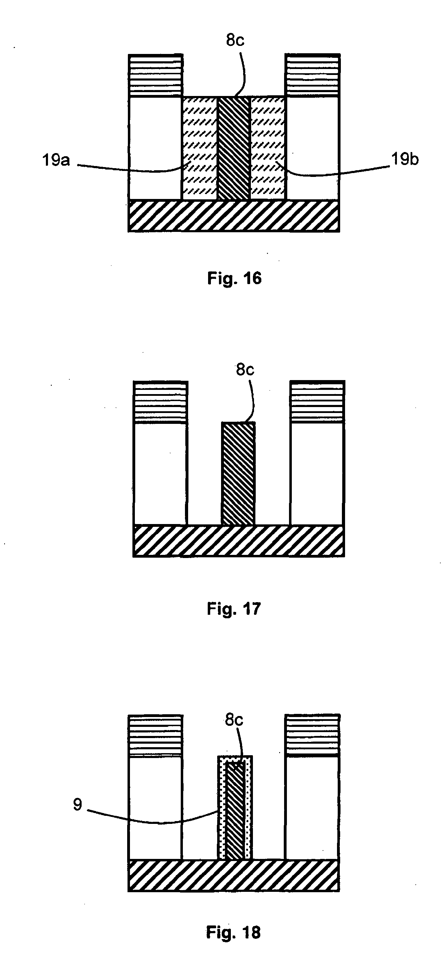

La figure 16 représente la formation de l'élément conducteur 8c. Une couche en matériau conducteur, par exemple en silicium dopé, est formée dans l'espace compris entre les espaceurs 19a et 19b puis amincie pour être à niveau avec les espaceurs 19a et 19b. L'amincissement est, par exemple, réalisé par polissage mécano-chimique ou attaque chimique. Le dopage peut être réalisé consécutivement au dépôt par une implantation ionique localisée ou au cours du dépôt par apport de dopants sous forme gazeuse.

A la figure 17, les espaceurs 19a et 19b sont ensuite éliminés, sélectivement par rapport aux couches 16, 17 et au matériau de l'élément 8c.

A la figure 18, l'élément 8c est enrobé d'un matériau électriquement isolant 9. Le matériau 9 est, de préférence, formé en oxydant en surface l'élément 8c. L'oxydation est, par exemple, réalisée par un traitement thermique sous oxygène. Dans le cas d'un élément 8c en silicium, de l'oxyde de silicium $SiO_2$ est obtenu.

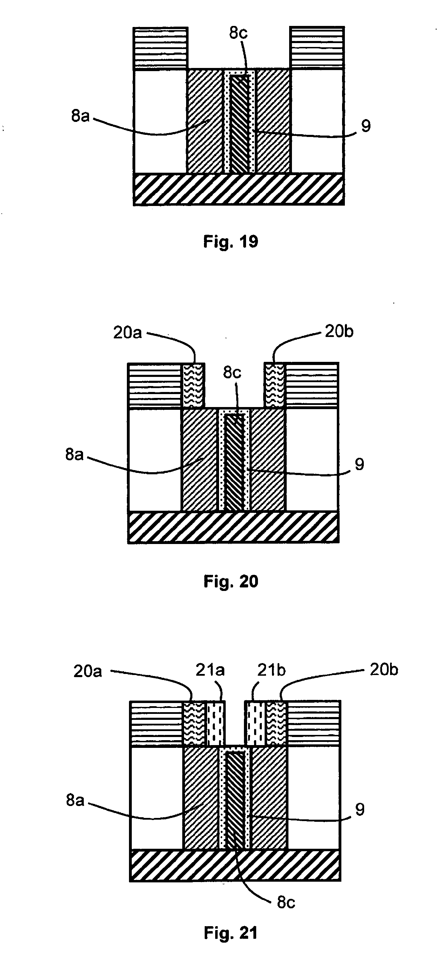

A la figure 19, un matériau conducteur de l'élément 8a est formé de part et d'autre de l'élément 8c, puis aminci pour former une face plane avec l'isolant 9 sur la partie supérieure de l'élément 8c. Le matériau de l'élément 8a est, par exemple, identique au matériau de l'élément 8c.

Les figures 20 et 21 représentent la formation d'espaceurs 20a, 20b, 21a et 21c au-dessus des éléments 8a et 8c. Les espaceurs 20a et 20b recouvrent une partie de l'élément 8a uniquement, de chaque côté de l'élément 8c. Les espaceurs 21a et 21b, respectivement en contact avec les espaceurs 20a et 20b, recouvrent en partie l'élément 8a et en partie le matériau isolant 9. La zone libre comprise entre les espaceurs 21a et 21b se situe approximativement au-dessus de l'élément 8c mais ne déborde pas sur l'élément 8a.

Les étapes décrites en relation avec les figures 13 à 21 sont communes à tous les plots thermoélectriques 2a et 2b du dispositif.

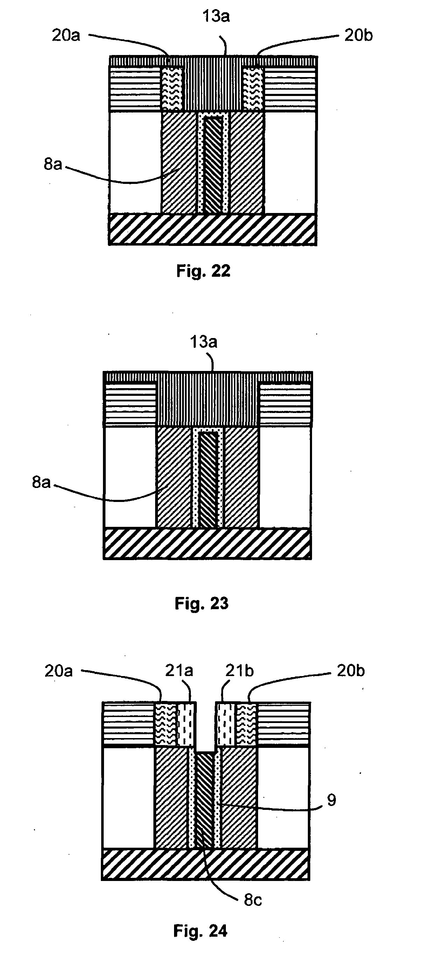

Les figures 22 à 25 illustrent une deuxième série d'étapes du procédé de réalisation. Elles correspondent à la formation des connexions électriques entre les plots. Les figures 22 et 23 représentent la formation de la couche métallique 13a.

A la figure 22, les espaceurs 21 a et 21b sont gravés dans une zone préalablement définie par photolithographie. Cette zone est prévue pour la réalisation de la couche métallique 13a en contact avec l'élément 8a du premier plot et l'élément 8c du deuxième plot (non représenté). Ainsi, un accès à l'élément 8a est obtenu en éliminant les espaceurs 21a et 21b. Puis, la couche métallique 13a est déposée dans l'espace compris entre les espaceurs 20a et 20b. La couche 13a est, de préférence, aplanie par polissage mécano-chimique.

Dans une variante de réalisation représentée à la figure 23, tous les espaceurs sont éliminés. Ainsi, le contact de la couche 13a sur l'élément 8a s'effectue sur la totalité de la face supérieure de l'élément 8a.

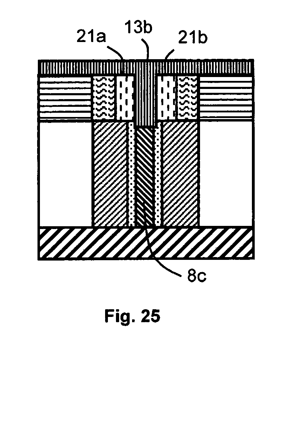

Les figures 24 et 25 représentent la formation de la couche métallique 13b.

A la figure 24, dans une autre zone également définie par photolithographie, une partie supérieure du matériau isolant 9 est gravée. Cette gravure ouvre l'accès à l'élément 8c afin d'y réaliser dans une étape future le contact électrique. Les espaceurs 21a et 21b servent, de préférence, de masque de gravure. La zone d'accès se situe donc en dessous de l'espace compris entre les espaceurs 21a et 21b.

A la figure 25, la couche métallique 13b est déposée dans l'espace compris entre les espaceurs 21a et 21b, puis éventuellement aplanie par polissage mécano-chimique.

Le procédé de réalisation a été décrit en relation avec le plot 2a à l'aide de ses références. Néanmoins, le procédé s'applique tel quel aux autres plots thermoélectriques du dispositif, par exemple le plot 2b représenté à la figure 4.

Les éléments conducteurs d'un même plot sont, de préférence, dans des matériaux de même nature thermoélectrique. Typiquement, les éléments conducteurs peuvent tous être en silicium, les éléments 8a et 8c du plot 2a pouvant être dopés de type n et les éléments 8b et 8d du plot 2b pouvant être dopés de type p. Dans un autre exemple, les éléments 8a et 8b sont en silicium, respectivement dopé n et p, tandis que les éléments 8c et 8d sont en un alliage silicium-germanium, respectivement dopé n et p.

**Revendications**

1.  Dispositif thermoélectrique comprenant des premier et second plots (2a, 2b) ayant des premières extrémités en contact avec une première face (5) et des secondes extrémités en contact avec une seconde face (6), les premier et second plots comprenant respectivement des premier et deuxième éléments conducteurs (8a, 8b) s'étendant continûment entre les première et seconde faces,
    **caractérisé en ce que** les premier et second plots (2a, 2b) comprennent respectivement des troisième et quatrième éléments conducteurs (8c, 8d) s'étendant continûment entre les première et seconde faces, le troisième élément conducteur (8c) étant adjacent au premier élément conducteur (8a) et séparé du premier élément conducteur par un isolant (9) et le quatrième élément conducteur (8d) étant adjacent au deuxième élément conducteur (8b) et séparé du deuxième élément conducteur par un isolant (10),
    et **en ce qu'**il comprend des moyens de sélection permettant la formation d'un premier thermocouple à partir des premier et deuxième éléments conducteurs (8a, 8b) et la formation d'un second thermocouple à partir des troisième et quatrième éléments conducteurs (8c, 8d).

2.  Dispositif selon la revendication 1, **caractérisé en ce que** les premier et troisième éléments conducteurs (8a, 8c) sont formés dans des matériaux de même nature thermoélectrique et les deuxième et quatrième éléments conducteurs (8b, 8d) sont formés dans des matériaux de même nature thermoélectrique.

3.  Dispositif selon la revendication 2, **caractérisé en ce que** les moyens de sélection comprennent un élément de connexion mobile (3) sur des faces externes des premier et second plots (2a, 2b), la face externe du premier plot (2a) exposant les premier et troisième éléments conducteurs (8a, 8c) et la face externe du second plot (2b) exposant les deuxième et quatrième éléments conducteurs (8b, 8d).

4.  Dispositif selon la revendication 3, **caractérisé en ce que** les premier et troisième éléments conducteurs (8a, 8c) sont des cylindres concentriques et **en ce que** les deuxième et quatrième éléments conducteurs (8b, 8d) sont des cylindriques concentriques.

5.  Dispositif selon la revendication 3, **caractérisé en ce que** l'élément de connexion mobile (3) comporte une partie centrale (3d) en matériau déformable et électriquement conducteur.

6.  Dispositif selon la revendication 3, **caractérisé en ce que** l'élément de connexion mobile (3) comporte une première partie (3a) en contact avec le premier plot (2a) et une seconde partie (3b) en contact avec le second plot (2b), les première et seconde parties étant mobiles l'une par rapport à l'autre.

7.  Dispositif selon la revendication 1, **caractérisé en ce que** les premier et deuxième éléments conducteurs (8a, 8b) ont une première section ($A_{np1}$) et **en ce que** les troisième et quatrième éléments conducteurs (8c, 8d) ont une seconde section ($A_{np2}$), différente de la première section ($A_{np1}$).

8.  Dispositif selon la revendication 7, **caractérisé en ce que** les moyens de sélection comprennent :

    - une première couche métallique (13a) reliant les premier et deuxième éléments conducteurs (8a, 8b),
    - une seconde couche métallique (13b), isolée électriquement de la première, reliant les troisième et quatrième éléments conducteurs (8c, 8d), et
- des moyens de commutation (14, T1, T2) pour mettre l'une ou l'autre des première et seconde couches métalliques dans un circuit électrique (V+, V-).

**9.** Dispositif selon la revendication 7, **caractérisé en ce que** la première section ($A_{np1}$) des premier et deuxième éléments conducteurs (8a, 8b) est dimensionnée pour favoriser l'un des deux effets Peltier et Seebeck et la seconde section ($A_{np2}$) des troisième et quatrième éléments conducteurs (8c, 8d) est dimensionnée pour favoriser l'autre des deux effets.

**10.** Dispositif selon la revendication 1, **caractérisé en ce que** le premier élément conducteur (8a) comprend deux parties disposées de chaque côté du troisième élément conducteur (8c) et **en ce que** le deuxième élément conducteur (8b) comprend deux parties disposées de chaque côté du quatrième élément conducteur (8d).

**Patentansprüche**

**1.** Thermoelektrische Vorrichtung, umfassend einen ersten und einen zweiten Kontakt (2a, 2b), die mit einer ersten Seite (5) in Kontakt befindliche erste Enden und mit einer zweiten Seite (6) in Kontakt befindliche zweite Enden aufweisen, wobei der erste und der zweite Kontakt ein erstes bzw. ein zweites leitendes Element (8a, 8b), die sich zwischen der ersten und der zweiten Seite durchgehend erstrecken, umfassen,
**dadurch gekennzeichnet, dass** der erste und der zweite Kontakt (2a, 2b) ein drittes bzw. ein viertes leitendes Element (8c, 8d), die sich zwischen der ersten und der zweiten Seite durchgehend erstrecken, umfassen, wobei das dritte leitende Element (8c) dem ersten leitenden Element (8a) benachbart ist und von dem ersten leitenden Element durch einen Isolator (9) getrennt ist und wobei das vierte leitende Element (8d) dem zweiten leitenden Element (8b) benachbart ist und von dem zweiten leitenden Element durch einen Isolator (10) getrennt ist,
und dass sie Auswahlmittel umfasst, die die Bildung eines ersten Thermoelements mittels des ersten und des zweiten leitenden Elements (8a, 8b) und die Bildung eines zweiten Thermoelements mittels des dritten und des vierten leitenden Elements (8c, 8d) ermöglichten.

**2.** Vorrichtung nach Anspruch 1, **dadurch gekennzeichnet, dass** das erste und das dritte leitende Element (8a, 8c) aus Materialien gleicher thermoelektrischer Art gebildet sind und das zweite und das vierte leitende Element (8b, 8d) aus Materialien gleicher thermoelektrischer Art gebildet sind.

**3.** Vorrichtung nach Anspruch 2, **dadurch gekennzeichnet, dass** die Auswahlmittel ein bewegliches Verbindungselement (3) an Außenseiten des ersten und des zweiten Kontakts (2a, 2b) umfassen, wobei die Außenseite des ersten Kontakts (2a) das erste und das dritte leitende Element (8a, 8c) offen legt und wobei die Außenseite des zweiten Kontakts (2b) das zweite und das vierte leitende Element (8b, 8d) offen legt.

**4.** Vorrichtung nach Anspruch 3, **dadurch gekennzeichnet, dass** das erste und das dritte leitende Element (8a, 8c) konzentrische Zylinder sind und dass das zweite und das vierte leitende Element (8b, 8d) konzentrische Zylinder sind.

**5.** Vorrichtung nach Anspruch 3, **dadurch gekennzeichnet, dass** das bewegliche Verbindungselement (3) einen mittleren Teil (3d) aus verformbarem und elektrisch leitendem Material umfasst.

**6.** Vorrichtung nach Anspruch 3, **dadurch gekennzeichnet, dass** das bewegliche Verbindungelement (3) einen mit dem ersten Kontakt (2a) in Kontakt befindlichen ersten Teil (3a) und einen mit dem zweiten Kontakt (2b) in Kontakt befindlichen zweiten Teil (3b) umfasst, wobei der erste und der zweite Teil zueinander beweglich sind.

**7.** Vorrichtung nach Anspruch 1, **dadurch gekennzeichnet, dass** das erste und das zweite leitende Element (8a, 8b) einen ersten Querschnitt ($A_{np1}$) aufweisen und dass das dritte und das vierte leitende Element (8c. 8d) einen von dem ersten Querschnitt ($A_{np1}$) verschiedenen zweiten Querschnitt ($A_{np2}$) aufweisen.

**8.** Vorrichtung nach Anspruch 7, **dadurch gekennzeichnet, dass** die Auswahlmittel umfassen:

- eine erste Metallschicht (13a), die das erste und das zweite leitende Element (8a, 8b) verbindet,
- eine von der ersten elektrisch isolierte zweite Metallschicht (13b), die das dritte und das vierte leitende Element (8c, 8d) verbindet, und
- Umschaltmittel (14, T1, T2), um die eine oder die andere der ersten und zweiten Metallschichten in einen elektrische Schaltkreis (V+, V-) einzuschalten.

9. Vorrichtung nach Anspruch 7, **dadurch gekennzeichnet, dass** der erste Querschnitt ($A_{np1}$) des ersten und des zweiten leitenden Elements (8a, 8b) bemessen ist, um einen der beiden Effekte, Peltier-Effekt und Seebeck-Effekt, zu begünstigen, und der zweite Querschnitt ($A_{np2}$) des dritten und des vierten leitenden Elements (8c, 8d) bemessen ist, um den anderen der beiden Effekte zu begünstigen.

10. Vorrichtung nach Anspruch 1, **dadurch gekennzeichnet, dass** das erste leitende Element (8a) zwei Teile, die auf jeder Seite des dritten leitenden Elements (8c) angeordnet sind, umfasst, und dass das zweite leitende Element (8b) zwei Teile, die auf jeder Seite des vierten leitenden Elements (8d) angeordnet sind, umfasst.

**Claims**

1. Thermoelectric device comprising first and second legs (2a, 2b) having first ends in contact with a first surface (5) and second ends in contact with a second surface (6), the first and second legs respectively comprising first and second conducting elements (8a, 8b) extending continuously between the first and second surfaces, **characterized in that** the first and second legs (2a, 2b) respectively comprise third and fourth conducting elements (8c, 8d) extending continuously between the first and second surfaces, the third conducting element (8c) being adjacent to the first conducting element (8a) and separated from the first conducting element by an insulator (9) and the fourth conducting element (8d) being adjacent to the second conducting element (8b) and separated from the second conducting element by an insulator (10), and **in that** it comprises selection means enabling formation of a first thermocouple from the first and second conducting elements (8a, 8b) and formation of a second thermocouple from the third and fourth conducting elements (8c, 8d).

2. The device according to claim 1, **characterized in that** the first and third conducting elements (8a, 8c) are formed from materials of the same thermoelectric nature and the second and fourth conducting elements (8b, 8d) are formed from materials of the same thermoelectric nature.

3. The device according to claim 2, **characterized in that** the selection means comprise a movable connecting element (3) on external surfaces of the first and second legs (2a, 2b), the external surface of the first leg (2a) exposing the first and third conducting elements (8a, 8c) and the external surface of the second leg (2b) exposing the second and fourth conducting elements (8b, 8d).

4. The device according to claim 3, **characterized in that** the first and third conducting elements (8a, 8c) are concentric cylinders and **in that** the second and fourth conducting elements (8b, 8d) are concentric cylinders.

5. The device according to claim 3, **characterized in that** the movable connecting element (3) comprises a central part (3d) made from deformable and electrically conducting material.

6. The device according to claim 3, **characterized in that** the movable connecting element (3) comprises a first part (3a) in contact with the first leg (2a) and a second part (3b) in contact with the second leg (2b), the first and second parts being movable with respect to one another.

7. The device according to claim 1, **characterized in that** the first and second conducting elements (8a, 8b) have a first cross-section ($A_{np1}$) and **in that** the third and fourth conducting elements (8c, 8d) have a second cross-section ($A_{np2}$), different from the first cross-section ($A_{np1}$).

8. The device according to claim 7, **characterized in that** the selection means comprise:

   - a first metal layer (13a) connecting the first and second conducting elements (8a, 8b),
   - a second metal layer (13b), electrically insulated from the first metal layer, connecting the third and fourth conducting elements (8c, 8d), and
   - switching means (14, T1, T2) to connect one or the other of the first and second metal layers in an electric circuit (V+, V-).

9. The device according to claim 7, **characterized in that** the first cross-section ($A_{np1}$) of the first and second conducting elements (8a, 8b) is dimensioned to favour one of the two Peltier and Seebeck effects and the second cross-section ($A_{np2}$) of the third and fourth conducting elements (8c, 8d) is dimensioned to favour the other of the two effects.

10. The device according to claim 1, **characterized in that** the first conducting element (8a) comprises two parts arranged on each side of the third conducting element (8c) and **in that** the second conducting element (8b) comprises two parts arranged on each side of the fourth conducting element (8d).

**Fig. 1 (Art antérieur)**

**Fig. 2**

Fig. 3

Fig. 4

Fig. 5

Fig. 6

**Fig. 7**

**Fig. 8**

**Fig. 9**

**Fig. 10**

**Fig. 11**

**Fig. 12**

**Fig. 13**

**Fig. 14**

**Fig. 15**

8c

19a                                                                        19b

**Fig. 16**

8c

**Fig. 17**

8c

9

**Fig. 18**

**Fig. 19**

**Fig. 20**

**Fig. 21**

13a

20a

20b

8a

**Fig. 22**

13a

8a

**Fig. 23**

20a     21a     21b     20b

9

8c

**Fig. 24**

Fig. 25

**EP 2 567 415 B1**

**Documents brevets cités dans la description**

- DE 3202791 A1